# EUROPEAN PATENT APPLICATION

(11) **EP 4 778 801 A1**
(43) Date of publication of application: **22.07.2026**
(21) Application number: 23952281.6
(22) Date of filing: 15.09.2023
(51) Int. Cl.: B60W 50/04, B60W 40/02, B60W 60/00, G06F 30/20, G08G 1/00, G08G 1/09, G08G 1/16

(54) **EVALUATION SCENARIO GENERATION DEVICE, EVALUATION SCENARIO GENERATION METHOD, AND AUTONOMOUS VEHICLE**

(71) Applicant: Astemo, Ltd., Chiyoda-ku, Tokyo 1000004 (JP)
(72) Inventor: MITA Ryota, Hitachinaka-shi, Ibaraki 312-8503 (JP); KANAI Masayuki, Hitachinaka-shi, Ibaraki 312-8503 (JP)
(74) Representative: MERH-IP Matias Erny Reichl Hoffmann Patentanwälte PartG mbB
(86) International application number: PCT/JP2023/033662
(87) International publication number: WO 2025/057392

(57) **Abstract**

Provided is an evaluation scenario generation device that automatically generates, with good efficiency, an evaluation scenario reproducing an intricate traffic disturbance scenario and executable by a simulator. An evaluation scenario generation device including: a storage unit that stores a plurality of evaluation scenario elements relevant to traveling environments of an ego vehicle, a plurality of parameters relevant to the evaluation scenario elements, and a group definition file defining contents relevant to categories of the evaluation scenarios; an evaluation scenario generation unit that generates a plurality of evaluation scenarios and a plurality of tag information items, based on the plurality of evaluation scenario elements and the plurality of parameters; and an evaluation scenario extraction unit that determines whether the evaluation scenarios are evaluation scenarios conforming to the group definition file, based on a result of a scene determination acquired by performing simulations of the evaluation scenarios based on the group definition file and the tag information items.

## Description

### Technical Field

The present invention relates to an evaluation scenario generation device and an evaluation scenario generation method that automatically generate an evaluation scenario used for evaluating and verifying an automated driving system, as well as an autonomous vehicle that travels in an automated manner using the generated evaluation scenario.

### Background Art

In developing an automated driving system for automobiles, it is necessary to evaluate and verify the safety of the automated driving system at respective stages of planning, design, and evaluation. As guidelines that describe a methodology of the evaluation and verification, "Automated Driving Safety Evaluation Framework" published by the Japan Automobile Manufacturers Association, Inc. has been known.

This guideline proposes a variety of traffic disturbance scenarios obtained by translating, into scenarios, the positional relationships between traffic participants and road geometries and the motions of traffic participants. By simulating the variety of traffic disturbance scenarios using a simulator, it is possible to appropriately evaluate and verify the safety of software and hardware of an automated driving system under development. In order to simulate the traffic disturbance scenarios, it is necessary to previously prepare files that define the traffic disturbance scenarios in a format executable by the simulator (computer) (hereinafter, such files are referred to as "evaluation scenarios").

As a conventional technique for automatically generating a large number of evaluation scenarios, a scenario generation device of PTL 1 has been known. For example, the abstract of this patent literature discloses, as "a scenario generation device capable of increasing the comprehensiveness of scenarios that occur in a real environment while suppressing the number of scenarios", a scenario generation device "that includes: a real environment scene obtaining unit obtaining a real environment scene, which is a scene that occurs in a real environment, from a travel database that stores travel data of a real vehicle; a filter generation unit generating a filter for filtering candidate scenarios based on a frequency analysis result of analysis target data including the travel data showing the real environment scene; and an evaluation scenario determination unit determining an evaluation scenario by filtering the candidate scenarios comprehensively generated based on a mathematical model using the filter generated by the filter generation unit".

### Citation List

### Patent Literature

PTL 1: JP 2023-50387 A

### Summary of Invention

### Technical Problem

The foregoing guideline also exemplifies many traffic disturbance scenarios in which the positional relationships between traffic participants and road geometries are intricately intertwined with the motions of traffic participants.

A blind spot scenario is an example of the intricate scenarios. The blind spot scenario is, for example, a scenario, in a scene of three vehicles, i.e., an ego vehicle, a surrounding vehicle, and a blind spot vehicle traveling on a road, for verifying whether an automated driving system of the ego vehicle can appropriately respond to the blind spot vehicle in a case where vehicle motions, such as cut-in, are produced successively after the surrounding vehicle and the blind spot vehicle are in such a positional relationship that the blind spot vehicle is hidden by the surrounding vehicle (blind spot relationship) as seen from a driver's eye in the ego vehicle or from an external sensor of the ego vehicle.

An avoidance motion scenario is another example of the intricate scenarios. The avoidance motion scenario is, for example, a scenario, in a case where three vehicles, i.e., an ego vehicle, a preceding vehicle, and a surrounding vehicle are traveling on a road, and the ego vehicle takes an avoidance measure to move to an area rearward of the ego vehicle due to a sudden deceleration of the preceding vehicle, for verifying whether an automated driving system of the ego vehicle can take a secondary avoidance measure for responding to the surrounding vehicle even when the surrounding vehicle also moves to the same area.

As described above, the evaluation scenarios are the files that define the traffic disturbance scenarios in the simulator-executable format. More specifically, the evaluation scenarios are files that specifically define road geometries, natural and built environments, geographic features, the location and motion of an ego vehicle for each step, the location and motion of a surrounding vehicle for each step, and the like.

Since the evaluation scenarios define, for each step, the location and motion of each vehicle to be simulated, it is possible to easily grasp the location and motion of each vehicle at a point in time of a start of each step, from the evaluation scenarios; however, it is difficult to recognize the location and motion of each vehicle during execution of each step unless a simulation is performed actually. In other words, even when a large number of evaluation scenarios are generated automatically, it is not easy to determine which evaluation scenarios correspond to intricate traffic disturbance scenarios such as the blind spot scenario and the avoidance motion scenario.

This means that it is difficult to automatically generate, by intention, intricate traffic disturbance scenarios, such as the blind spot scenario and the avoidance motion scenario, to be evaluated and verified predominantly for assurance of the safety of an automated driving system and it is difficult to extract only intricate traffic disturbance scenarios from among a vast number of automatically generated evaluation scenarios. According to the conventional technique, consequently, it has been difficult to sufficiently evaluate and verify, under a variety of traffic disturbance scenarios, the safety of software and hardware of an automated driving system under development.

Hence, an object of the present invention is to provide an evaluation scenario generation device and an evaluation scenario generation method that can automatically generate, with good efficiency, a variety of evaluation scenarios reproducing intricate traffic disturbance scenarios, as well as an autonomous vehicle that travels using the generated evaluation scenarios.

### Solution to Problem

In order to solve the foregoing problems, a representative example of the invention disclosed in the present invention is as follows. That is, an evaluation scenario generation device of the present invention is an evaluation scenario generation device including: a storage unit that stores a plurality of evaluation scenario elements relevant to traveling environments of an ego vehicle, a plurality of parameters relevant to the evaluation scenario elements, and a group definition file defining contents relevant to categories of the evaluation scenarios; an evaluation scenario generation unit that generates a plurality of evaluation scenarios and a plurality of tag information items, based on the plurality of evaluation scenario elements and the plurality of parameters; and an evaluation scenario extraction unit that determines whether the evaluation scenarios are evaluation scenarios conforming to the group definition file, based on a result of a scene determination acquired by performing simulations of the evaluation scenarios based on the group definition file and the tag information items.

### Advantageous Effects of Invention

According to the present invention, it is possible to automatically generate, with good efficiency, a variety of evaluation scenarios reproducing intricate traffic disturbance scenarios. Problems, configurations, and effects other than those described above will be clarified by the following description of embodiments.

### Brief Description of Drawings

[FIG. 1] FIG. 1 is a configuration diagram of an evaluation scenario generation device of Embodiment 1.
[FIG. 2] FIG. 2 is a flowchart of an evaluation scenario extraction unit of Embodiment 1.
[FIG. 3A] FIG. 3A is a diagram illustrating a content of an evaluation scenario of Embodiment 1.
[FIG. 3B] FIG. 3B is a diagram representing the content of the evaluation scenario of Embodiment 1.
[FIG. 3C] FIG. 3C is a diagram illustrating a tag information item of the evaluation scenario of Embodiment 1.
[FIG. 4A] FIG. 4A is a diagram illustrating a content of a group definition file of Embodiment 1.
[FIG. 4B] FIG. 4B is a diagram illustrating a result of processing in step S4 of Embodiment 1.
[FIG. 5A] FIG. 5A is a diagram illustrating a blind spot scenario determination method of Embodiment 1.
[FIG. 5B] FIG. 5B is a diagram illustrating an avoidance motion scenario determination method of Embodiment 1.
[FIG. 6A] FIG. 6A is a diagram illustrating a result of processing in step S8 and a result of processing in step S9 of Embodiment 1.
[FIG. 6B] FIG. 6B is a diagram illustrating a result of processing in step S10 of Embodiment 1.
[FIG. 6C] FIG. 6C is a diagram illustrating a result of processing by the evaluation scenario extraction unit of Embodiment 1.
[FIG. 7] FIG. 7 is a configuration diagram of an autonomous vehicle equipped with an evaluation scenario generation device of Embodiment 2.
[FIG. 8A] FIG. 8A is a diagram illustrating a scene in which the evaluation scenario generation device of Embodiment 2 is used for vehicle control.
[FIG. 8B] FIG. 8B is a diagram illustrating a result of a scene determination of Embodiment 2.
[FIG. 8C] FIG. 8C is a diagram illustrating a candidate avoidance area of Embodiment 2.
[FIG. 8D] FIG. 8D is a diagram illustrating an avoidance motion of an automated driving control device of Embodiment 2.
[FIG. 9] FIG. 9 is a configuration diagram of a server and an autonomous vehicle of Embodiment 3, which are connected by communications.

### Description of Embodiments

Embodiments of the present invention will be described below with reference to the drawings.

### Embodiment 1

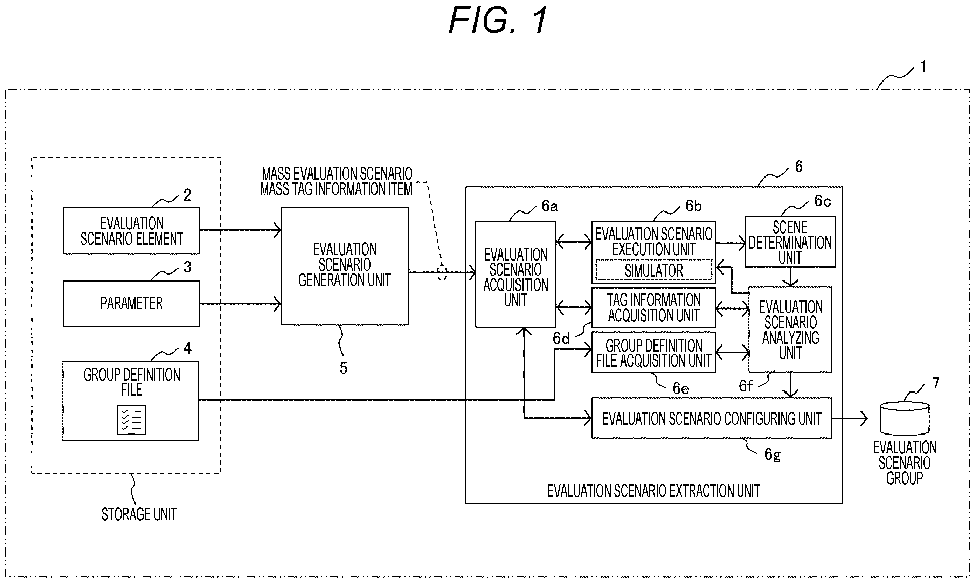

An evaluation scenario generation device 1 of Embodiment 1 will be described below with reference to FIGS. 1 to 6C.

FIG. 1 is a configuration diagram of the evaluation scenario generation device 1 of the present embodiment. As illustrated in FIG. 1, the evaluation scenario generation device 1 includes evaluation scenario elements 2, parameters 3, a group definition file 4, an evaluation scenario generation unit 5, an evaluation scenario extraction unit 6, and an evaluation scenario group 7. Specifically, the evaluation scenario generation device 1 is a computer including hardware, e.g., a computing device such as a CPU, a main storage device such as a semiconductor memory, an auxiliary storage device such as a hard disk, and a communication device. The computing device executes predetermined programs, thereby implementing functional units such as the evaluation scenario generation unit 5 and the evaluation scenario extraction unit 6. In the following, the details of these functional units will be described in sequence while the description of known techniques in the field of computers is omitted as appropriate.

### <Various data items stored in storage unit>

As illustrated in FIG. 1, the evaluation scenario generation device 1 includes a storage unit (auxiliary storage device) that stores the evaluation scenario elements 2, the parameters 3, and the group definition file 4.

The evaluation scenario elements 2 are elements configuring evaluation scenarios, and correspond to data items previously registered in the storage unit. The evaluation scenario elements 2 include various elements relevant to traveling environments of an ego vehicle, such as road geometries (straight, ramp, merge, branch, intersection, etc.), traffic participants (vehicle, truck, motorcycle, pedestrian, etc.), motions of the traffic participants (constant speed, acceleration, deceleration, lane change, preceding vehicle follow, right/left-hand turn, etc.), natural and built environments (wall, guardrail, house, building, traffic sign, etc.), and geographic features.

The parameters 3 are parameters specifically defining the evaluation scenario elements 2, and correspond to data items previously registered in the storage unit. The parameters 3 include numeric values, ranges, and states for defining the respective elements.

The group definition file 4 is a file defining the evaluation scenario group 7, and is constituted of data items previously registered in the storage unit. The group definition file 4 includes standards, specifications, guidelines, and the like for categorizing evaluation scenarios generated by the evaluation scenario generation unit 5.

### <Evaluation scenario generation unit 5>

The evaluation scenario generation unit 5 generates a plurality of evaluation scenarios and a plurality of tag information items (described later), based on the input evaluation scenario elements 2 and parameters 3. The evaluation scenario generation unit 5, if possible, generates all evaluation scenarios and tag information items that can be generated from combinations of the evaluation scenario elements 2 and the parameters 3. In a case where generating all the evaluation scenarios and tag information items is not realistic in consideration of, for example, time required for simulations, the evaluation scenario generation unit 5 generates a randomly combined number (limited number) of evaluation scenarios and tag information items while securing comprehensiveness. In any case, the evaluation scenario generation unit 5 generates a large number of evaluation scenarios and a large number of tag information items (hereinafter, mass evaluation scenarios and mass tag information items) by which the safety of an automated driving system can be evaluated and verified sufficiently.

### <Evaluation scenario extraction unit 6>

The evaluation scenario extraction unit 6 receives the mass evaluation scenarios, the mass tag information items, and the group definition file 4. The evaluation scenario extraction unit 6 then determines whether the evaluation scenarios generated by the evaluation scenario generation unit 5 are desired evaluation scenarios (e.g., blind spot scenario) defined in the group definition file 4, and outputs a group of the corresponding evaluation scenarios as the evaluation scenario group 7.

As illustrated in FIG. 1, the evaluation scenario extraction unit 6 includes an evaluation scenario acquisition unit 6a, an evaluation scenario execution unit 6b, a scene determination unit 6c, a tag information acquisition unit 6d, a group definition file acquisition unit 6e, an evaluation scenario analyzing unit 6f, and an evaluation scenario configuring unit 6g. The details of each unit will be described later. The outline of each unit is as follows.

The evaluation scenario acquisition unit 6a acquires the mass evaluation scenarios and the mass tag information items from the evaluation scenario generation unit 5, and manages the acquired mass evaluation scenarios and mass tag information items.

The evaluation scenario execution unit 6b includes a simulator that simulates an analysis target evaluation scenario.

The scene determination unit 6c makes a scene determination on a result of a simulation by the evaluation scenario execution unit 6b.

The tag information acquisition unit 6d acquires analysis target tag information items from the evaluation scenario acquisition unit 6a, and edits the contents of the tag information items if necessary.

The group definition file acquisition unit 6e acquires the group definition file 4, and adds information items to the group definition file if necessary.

The evaluation scenario analyzing unit 6f refers to the tag information items acquired by the tag information acquisition unit 6d and the group definition file 4 acquired by the group definition file acquisition unit 6e, and determines whether analysis target evaluation scenarios are desired evaluation scenarios (e.g., blind spot scenario) defined in the group definition file 4.

The evaluation scenario configuring unit 6g retrieves group information items of the mass tag information items managed by the evaluation scenario acquisition unit 6a, extracts evaluation scenarios that are in accord with the group information items defined in the group definition file, and generates the evaluation scenario group 7.

### <Evaluation scenario group 7>

The evaluation scenario group 7 is a group of the evaluation scenarios output by the evaluation scenario configuring unit 6g, and is constituted of the desired evaluation scenarios (e.g., blind spot scenario) defined in the group definition file 4. Moreover, the evaluation scenario group 7 is input to a separately provided simulator (not illustrated) for an automated driving system, and traffic disturbance scenarios are reproduced by simulations and are used for evaluation and verification of the safety of the automated driving system.

### <Flowchart of evaluation scenario extraction processing>

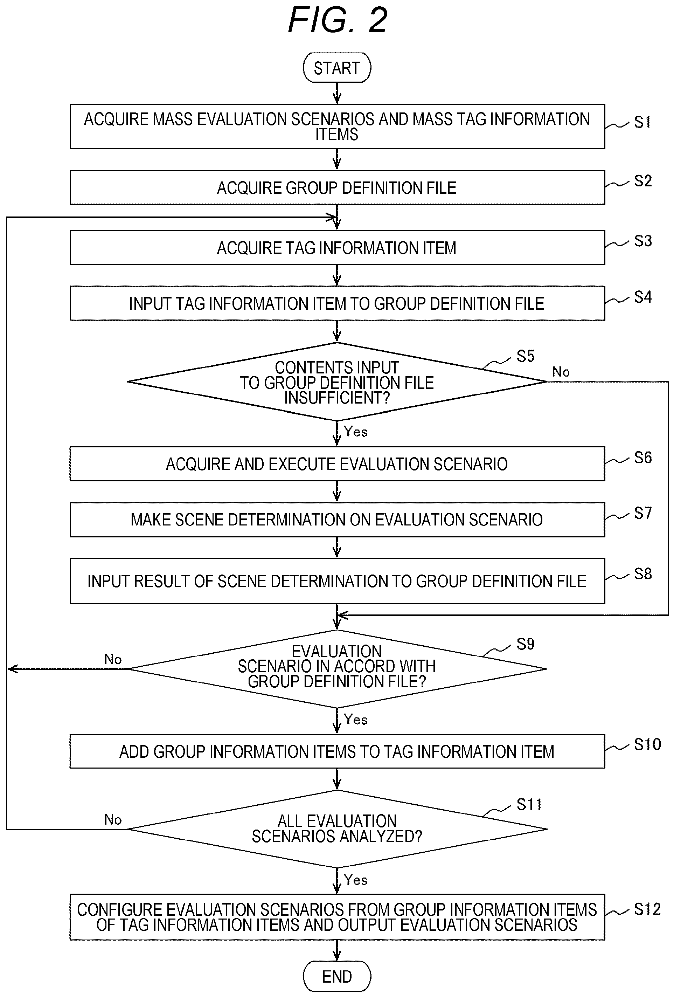

FIG. 2 is a flowchart of processing to be performed by the evaluation scenario extraction unit 6. Steps of the flowchart will be described below.

### <<Step S1>>

In this step, the evaluation scenario acquisition unit 6a acquires the mass evaluation scenarios and mass tag information items generated by the evaluation scenario generation unit 5.

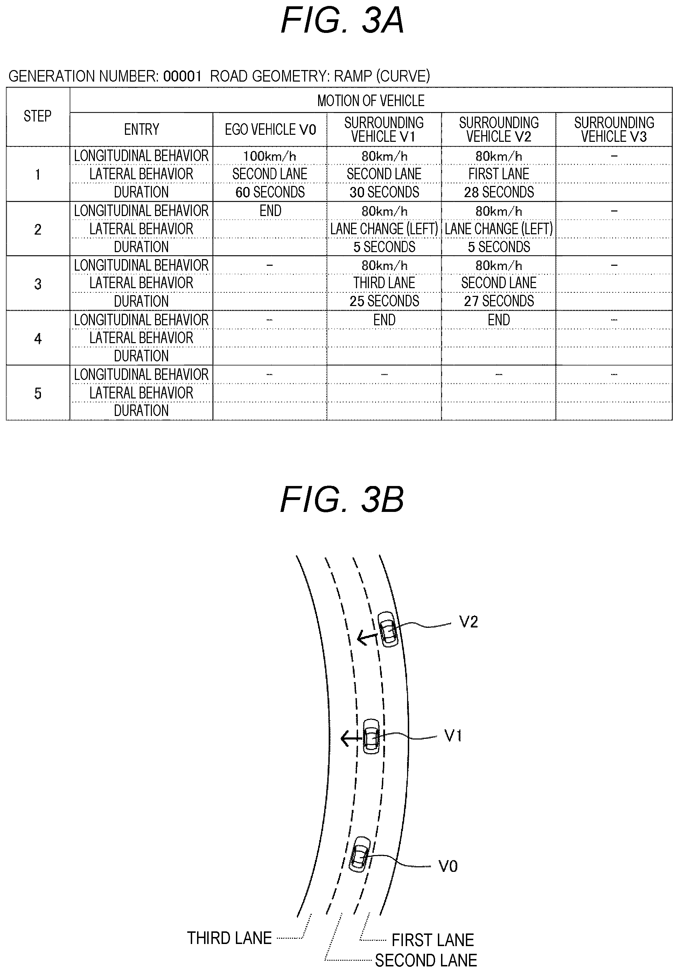

FIG. 3A is a diagram illustrating an exemplary evaluation scenario generated by the evaluation scenario generation unit 5. This evaluation scenario defines, in a case where a road geometry is a ramp (curve) and traffic participants are an ego vehicle V0, a surrounding vehicle V1, and a surrounding vehicle V2, the location and motion of each vehicle for each step. It should be noted that FIG. 3A briefly illustrates the motions of the traffic participants, i.e., the ego vehicle V0, the surrounding vehicle V1, and the surrounding vehicle V2, but does not illustrate the others for convenience. FIG. 3B is a conceptual view of the evaluation scenario of FIG. 3A represented in the form of a plan view.

The evaluation scenario of FIG. 3A defines the motions of the three vehicles for each step, and a simulation time is 60 seconds. The motion of each vehicle is defined by parameters of a longitudinal behavior, a lateral behavior, and a duration. The motion of each vehicle will be described with reference to FIGS. 3A and 3B. First, the ego vehicle V0 travels on a second lane at the center of the ramp at 100 km/h for 60 seconds. The surrounding vehicle V1 travels ahead of the ego vehicle V0 on the second lane at 80 km/h for 30 seconds, makes a lane change to a third lane on the left side of the second lane in 5 seconds, and then travels on the third lane at 80 km/h for 25 seconds. The surrounding vehicle V2 travels ahead of the surrounding vehicle V1 on a first lane on the right side of the second lane at 80 km/h for 28 seconds, makes a lane change to the second lane in 5 seconds, and then travels on the second lane at 80 km/h for 27 seconds.

The evaluation scenario of FIG. 3A aims at reproducing a blind spot scenario which is the following scene. That is, when the ego vehicle V0 approaches the surrounding vehicle V1 and shortens a distance from the ego vehicle V0 to the surrounding vehicle V1, the surrounding vehicle V2 is hidden by the surrounding vehicle V1 so as to have a positional relationship of a blind spot with respect to the ego vehicle V0. At this timing, since the surrounding vehicle V1 and the surrounding vehicle V2 each make a lane change to the left, it looks like the surrounding vehicle V2 suddenly appears in front of the ego vehicle V0. As described above, however, it is impossible to grasp the motion of each vehicle during execution of a step from only the contents of the evaluation scenario of FIG. 3A; therefore, it is impossible to determine whether intricate vehicle motions such as those in the blind spot scenario occur.

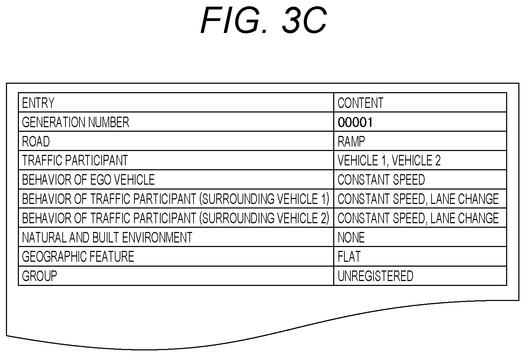

FIG. 3C illustrates an exemplary tag information item of the evaluation scenario of FIG. 3A. The tag information item is an information item prepared concurrently with the evaluation scenario generated by the evaluation scenario generation unit 5, and is associated with the evaluation scenario using a generation number (e.g., "00001") issued by the evaluation scenario generation unit 5. As illustrated as an example in FIG. 3C, the tag information item includes the contents and parameter values of the evaluation scenario elements used for the generation of the evaluation scenario. Therefore, the contents of the evaluation scenario can be roughly determined from the tag information item. In FIG. 3C, an unregistered entry "group" is added after scene determination processing (described later).

The foregoing description has been given of an exemplary evaluation scenario and an exemplary tag information item. The mass evaluation scenarios are a large number of evaluation scenarios about which the road geometries, the locations, longitudinal behaviors, and lateral behaviors of the respective vehicles, the measurement times, the number of steps, the number of vehicles, and the like are different from each other, and the mass tag information items are a large number of tag information items associated with the large number of evaluation scenarios. The mass evaluation scenarios and the mass tag information items are generated by the evaluation scenario generation unit 5 in large quantities and stored in the evaluation scenario acquisition unit 6a in a state in which it is unknown whether each of the evaluation scenarios is a blind spot scenario or an avoidance motion scenario.

### <<Step S2>>

In this step, the group definition file acquisition unit 6e acquires the group definition file 4.

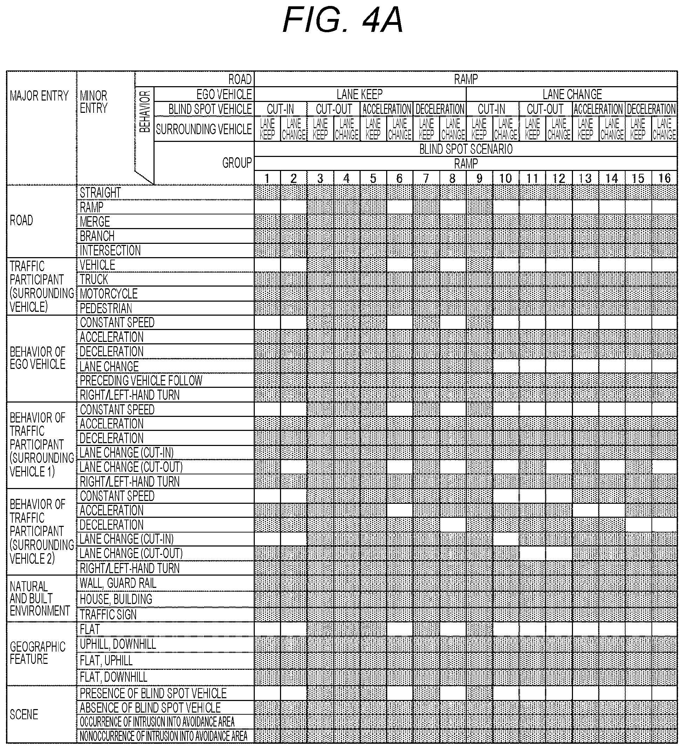

FIG. 4A is a diagram illustrating an exemplary group definition file. In this group definition file, a blind spot scenario in a case where the road geometry is "ramp" is defined as a desired evaluation scenario. FIG. 4A illustrates the group definition file in the format of a simple table for convenience; however, the format of the group definition file is not limited to that illustrated as an example in FIG. 4A.

In FIG. 4A, column entries indicate checkpoints, such as "road", "traffic participant", and "behavior of ego vehicle", for determining the contents of an evaluation scenario, and row entries indicate checkpoints, such as "ramp", "lane keep", and "cut-in", for determining whether the evaluation scenario is a desired evaluation scenario. This enables a determination as to whether the analysis target evaluation scenario is the desired evaluation scenario defined in the group definition file, by checking corresponding ones of the checkpoints of the column entries, and then getting hits for checkpoints of the row entries corresponding to "group". In FIG. 4A, the contents of the row entries corresponding to "group" are left blank, and the contents of the row entries not corresponding to "group" are hatched.

### <<Step S3>>

In this step, the tag information acquisition unit 6d acquires one analysis target tag information item from among the plurality of tag information items acquired by the evaluation scenario acquisition unit 6a.

### <<Step S4>>

In this step, the evaluation scenario analyzing unit 6f adds the contents of the tag information item acquired by the tag information acquisition unit 6d to the group definition file acquired by the group definition file acquisition unit 6e.

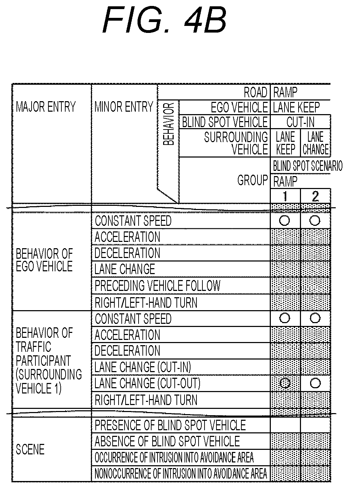

FIG. 4B illustrates a result of the processing in step S4 in a simplified manner for convenience. In FIG. 4B, round marks are placed in the fields of the column entries that are in accord with the contents of the tag information item.

### <<Step S5>>

In this step, the evaluation scenario analyzing unit 6f determines whether the contents input to the column entries of the group definition file after the processing in step S4 are insufficient. When the contents are insufficient (step S5: Yes), the processing proceeds to step S6. When the contents are sufficient (step S5: No), the processing proceeds to step S9.

In the example of FIG. 4B, no round marks are placed in the fields of the column entry "scene" of the group definition file, that is, the input contents are insufficient. Therefore, the processing proceeds to step S6.

### <<Step S6>>

In this step, the evaluation scenario analyzing unit 6f simulates the analysis target evaluation scenario, using the evaluation scenario execution unit 6b. With regard to the analysis target evaluation scenario, the corresponding evaluation scenario is selected from the evaluation scenarios stored in the evaluation scenario acquisition unit 6a, using the generation number of the tag information item acquired by the tag information acquisition unit 6d, and is input to the evaluation scenario execution unit 6b.

### <<Step S7>>

The scene determination unit 6c inputs a result of the simulation by the evaluation scenario execution unit 6b, and determines whether the analysis target evaluation scenario is a blind spot scenario or an avoidance motion scenario. A method of determining each scenario will be described below.

### <<<Blind spot scenario determination method>>>

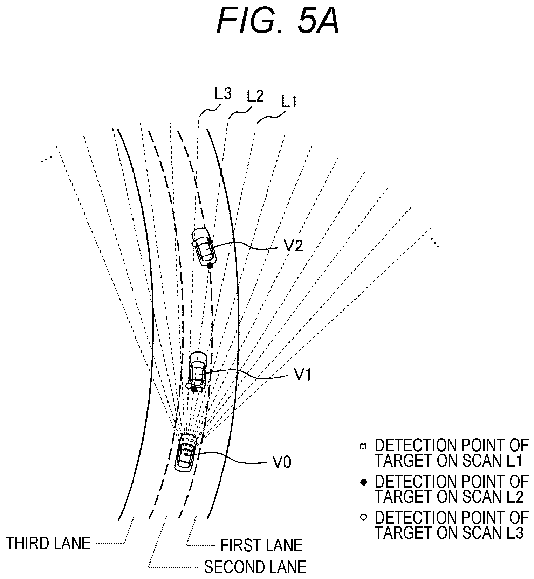

FIG. 5A is a conceptual view illustrating an exemplary blind spot scenario determination method. In FIG. 5A, the ego vehicle V0 and the surrounding vehicle V1, which travels ahead of the ego vehicle V0, travel on the central second lane, and the surrounding vehicle V2, which travels ahead of the surrounding vehicle V1, makes a lane change from the first lane to the second lane on the left side of the first lane. At this time, a distance between the ego vehicle V0 and the surrounding vehicle V1 is short, and the ego vehicle V0 cannot recognize the surrounding vehicle V2 since the surrounding vehicle V2 is in a blind spot relationship with the ego vehicle V0 due to the presence of the surrounding vehicle V1. Therefore, the scene determination unit 6c determines that the scenario of FIG. 5A is the blind spot scenario.

An example of this determination method is as follows. First, a reference point is provided on the ego vehicle V0, and scans for target detection are performed radially from the reference point. In a case where two or more targets are detected on the scanning lines (e.g., scan L2, scan L3), it can be determined that the target detected at a position far from the reference point is in a blind spot relationship with the target detected at a position near the reference point. On the other hand, in a case where one target or no target is detected on the scanning lines (e.g., scan L1), it can be determined that no blind spot relationship is established. Although the use of the foregoing method enables a determination of the blind spot scenario, a determination method is not limited to that described above, and another alternative method may be used.

### <<<Avoidance motion scenario determination method>>>

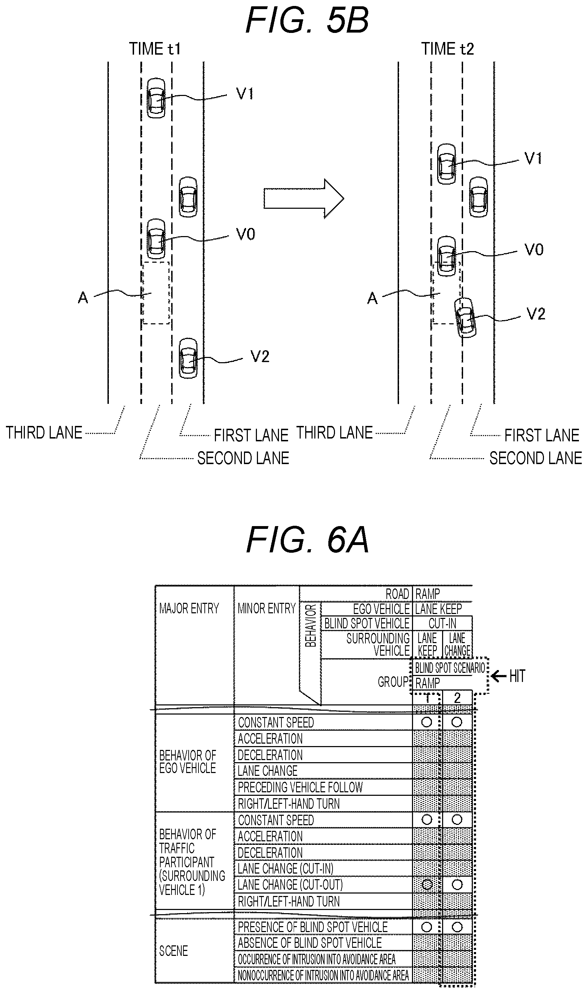

FIG. 5B is a conceptual view illustrating an exemplary avoidance motion scenario determination method. In FIG. 5B, the ego vehicle V0 and the preceding surrounding vehicle V1 travel on the central second lane, and the subsequent surrounding vehicle V2 travels on the first lane. At a time t1, since the surrounding vehicle V1 decelerates suddenly, the ego vehicle V0 intends to move to a rearward available area for collision avoidance. At a time t2, the surrounding vehicle V2 makes a lane change from the first lane to the second lane on the left side of the first lane, so that a distance between the surrounding vehicle V2 and the ego vehicle V0, which has moved to the rearward available area, becomes short suddenly. Therefore, since the ego vehicle V0 needs to take a secondary avoidance measure against the surrounding vehicle V2, the scene determination unit 6c determines that the scenario of FIG. 5B is the avoidance motion scenario.

An example of this determination method is as follows. First, an area A, which is an available area located rearward of the ego vehicle V0, is set and is subjected to target detection using an in-vehicle sensor. In a case where a target different from the ego vehicle V0 is detected in the area A (e.g., in a case where the surrounding vehicle V2 is detected at the time t2 in FIG. 5B), it can be determined that this scenario is the avoidance motion scenario. On the other hand, in a case where a target different from the ego vehicle V0 is not detected in the area A, it can be determined that this scenario is not the avoidance motion scenario. Although the use of the foregoing method enables a determination of the avoidance motion scenario, a determination method is not limited to that described above, and another alternative method may be used.

### <<Step S8>>

In this step, the evaluation scenario analyzing unit 6f adds the contents of the result of the scene determination, which are acquired from the scene determination unit 6c, to the group definition file of the group definition file acquisition unit 6e.

FIG. 6A illustrates a result of the processing in step S8 in a simplified manner for convenience. In FIG. 6A, round marks are placed in the fields of the minor column entry "presence of blind spot vehicle" in the major column entry "scene". This is because the evaluation scenario execution unit 6b simulates the evaluation scenario of FIG. 3A, the scene determination unit 6c determines that this evaluation scenario is the blind spot scenario, and then the evaluation scenario analyzing unit 6f acquires the result of the scene determination and inputs the result of the scene determination to the group definition file of the group definition file acquisition unit 6e.

### <<Step S9>>

In this step, the evaluation scenario analyzing unit 6f confirms the contents of the group definition file of the group definition file acquisition unit, and determines whether the contents are in accord with any of the minor row entries in the major row entry "group". When the contents are in accord with the minor row entries (step S9: Yes), the processing proceeds to step S10. When the contents are not in accord with the minor row entries (step S9: No), the processing returns to step S3.

FIG. 6A also illustrates a result of the processing in step S9. A group determination method involves finding, for example, a group where a round mark is placed in a blank field and no round mark is placed in a hatched field. In

FIG. 6A, a group of evaluation scenarios satisfying "blind spot scenario", "ramp", and "2" corresponds to this group. That is, it is determined that the analysis target evaluation scenario, which has been carried out in steps S3 to S9 as described above, belongs to the group of evaluation scenarios satisfying "blind spot scenario", "ramp", and "2".

### <<Step S10>>

In this step, the evaluation scenario analyzing unit 6f adds group information items acquired in step S9 to the tag information item of the tag information acquisition unit 6d, and the tag information acquisition unit 6d updates the analysis target tag information item stored in the evaluation scenario acquisition unit 6a to the latest tag information item including the group information items.

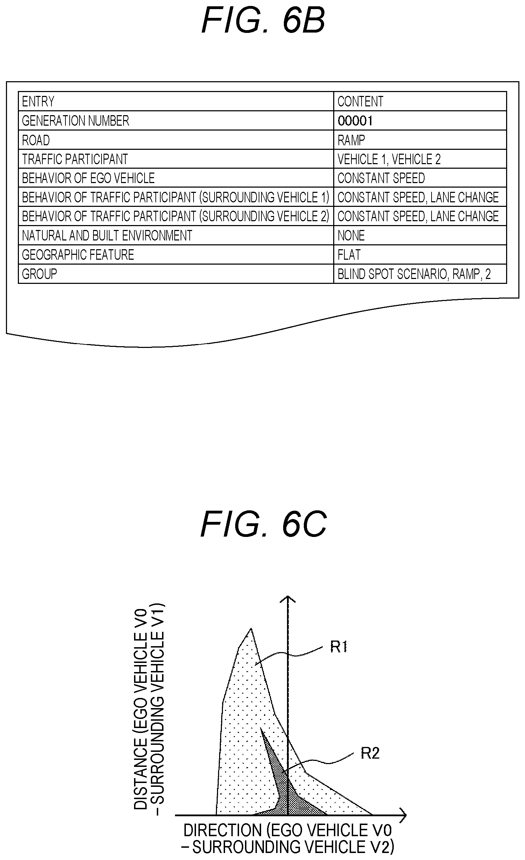

FIG. 6B illustrates a result of the processing in step S10. In FIG. 6B, "blind spot scenario", "ramp", and "2", which are the group information items determined in step S9, are added to the content, which has not been registered, of the entry "group" in FIG. 3C.

### <<Step S11>>

In this step, the evaluation scenario analyzing unit 6f determines whether all the mass evaluation scenarios have been analyzed. When all the mass evaluation scenarios have been analyzed (step S11: Yes), the processing proceeds to step S11. When all the mass evaluation scenarios have not been analyzed (step S11: No), the processing returns to step S3.

### <<Step S12>>

In this step, the evaluation scenario configuring unit 6g refers to the group information items from the mass tag information items of the evaluation scenario acquisition unit 6a, extracts the corresponding evaluation scenarios for each common group name, configures the extracted evaluation scenarios as an evaluation scenario group, and outputs the evaluation scenario group 7. It is thus possible to configure, for example, the evaluation scenario group 7 including only the blind spot scenarios and the evaluation scenario group 7 including only the avoidance motion scenarios.

The flowchart of FIG. 2 executed by the evaluation scenario extraction unit 6 has been described above. According to this processing, it is possible to extract, with good efficiency, specific intricate traffic disturbance scenarios (blind spot scenario, avoidance motion scenario) from the mass evaluation scenarios generated by the evaluation scenario generation unit 5. It is therefore possible to automatically generate, with good efficiency, a group including only the specific traffic disturbance scenarios by the evaluation scenario generation device 1 of the present embodiment.

### <Example of evaluation scenario group output from evaluation scenario extraction unit 6>

FIG. 6C is a conceptual view illustrating a result of the processing by the evaluation scenario extraction unit 6. FIG. 6C illustrates extraction of the evaluation scenario satisfying "blind spot scenario", "ramp", and "2" used for explaining the flowchart of FIG. 2. In this exemplary graph, the longitudinal axis represents a distance between the ego vehicle V0 and the surrounding vehicle V1, and the horizontal axis represents a direction of the ego vehicle V0 and surrounding vehicle V2. In FIG. 6C, a region R1 represents scenarios, which are not the blind spot scenarios, among the mass evaluation scenarios generated by the evaluation scenario generation unit 5. Also in FIG. 6C, a region R2 represents scenarios, which are the blind spot scenarios, among the mass evaluation scenarios generated by the evaluation scenario generation unit 5.

As described above, in the flowchart of FIG. 2, the evaluation scenario extraction unit 6 extracts the evaluation scenarios corresponding to the region R2 from the mass evaluation scenarios, and outputs the extracted evaluation scenarios as the evaluation scenario group 7. As previously described, the evaluation scenarios included in the evaluation scenario group 7 are subjected to accurate content analysis such as a scene determination based on simulations. It is therefore possible to automatically generate, with high accuracy, an evaluation scenario reproducing an intricate traffic disturbance.

### <Comparison between scenario generation efficiency according to conventional technique and scenario generation efficiency according to the present invention>

Scenario generation efficiency according to the present embodiment will be described here. Values shown in Table 1 are values used for estimating scenario generation efficiency. All the values of a number, a time, and the like for preparation are assumed values for convenience.

### [Table 1]

**Table 1**

| Entry | Value |
|---|---|
| Evaluation scenario simulation time | 60 seconds/scenario |
| Number of prepared evaluation scenarios | 400 scenarios |
| Time in manually preparing evaluation scenarios | 15 minutes/scenario |
| Time in generating 1000 evaluation scenarios by evaluation scenario generation unit 5 | 30 seconds |
| Speed of simulator 11 performing simulation | Speed 30 times actual time |
| Extraction rate of blind spot scenarios extracted by evaluation scenario extraction unit 6 | 40% |

Table 2 shows an exemplary result of estimating a time required for preparing 400 blind spot scenarios, for each evaluation scenario preparation method. An evaluation scenario preparation method M1 is a scenario preparation method of generating 400 blind spot scenarios in such a way that an ordinary user of simulator software for an automated driving system conducts all the processes manually. An evaluation scenario preparation method M2 is a scenario preparation method of preparing 1000 evaluation scenarios by the evaluation scenario generation unit 5 of the present embodiment, and then extracting 400 blind spot scenarios in such a way that the above ordinary user confirms the scenes manually. An evaluation scenario preparation method M3 is a scenario preparation method of preparing 1000 evaluation scenarios by the evaluation scenario generation unit 5, and then extracting 400 blind spot scenarios by the evaluation scenario extraction unit 6.

### [Table 2]

**Table 2**

| Entry | Preparation time | Efficiency |
|---|---|---|
| Evaluation scenario generation method M1 | 100 hours | 4 scenarios/hour |
| Evaluation scenario generation method M2 | 16.675 hours | 24 scenarios/hour |
| Evaluation scenario generation method M3 | 0.564 hours | 709 scenarios/hour |

In Table 2, "efficiency" indicates the number of evaluation scenarios prepared per hour. In the example of Table 2, therefore, the efficiency of the evaluation scenario preparation method M3 is about 177 times that of the evaluation scenario preparation method M1, and is about 29 times that of the evaluation scenario preparation method M2. The present embodiment applies to the evaluation scenario preparation method M3. Therefore, it is apparent from Table 2 that the evaluation scenario generation device 1 of the present embodiment is capable of automatically generating, with good efficiency, an evaluation scenario reproducing an intricate traffic disturbance scenario.

### Embodiment 2

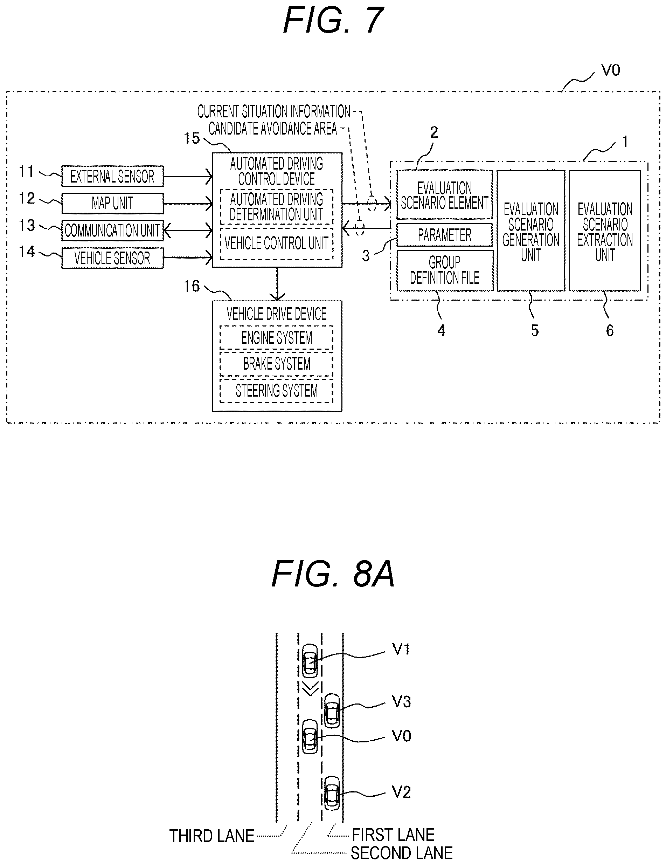

Next, an autonomous vehicle according to Embodiment 2 of the present invention will be described with reference to FIGS. 7 to 8D. In the following, features in common between Embodiment 2 and Embodiment 1 are not described for avoidance of redundancy.

FIG. 7 is a configuration diagram of an autonomous vehicle of the present embodiment (hereinafter, referred to as an "ego vehicle V0") utilizing an evaluation scenario generation device 1 for automated driving control. As illustrated in FIG. 7, the ego vehicle V0 includes, in addition to the evaluation scenario generation device 1, an external sensor 11, a map unit 12, a communication unit 13, a vehicle sensor 14, an automated driving control device 15, and a vehicle drive device 16. These components will be described below in sequence.

The external sensor 11 includes a camera sensor and a radar sensor. The camera sensor is a sensor that acquires object information detected from images of the surroundings of the ego vehicle. The radar sensor is a sensor that acquires object information detected from a distance to a predetermined point around the ego vehicle.

The map unit 12 is a unit that receives a satellite reception signal of the global navigation satellite system (also referred to as GNSS). The map unit 12 includes a map database and a locator. The map unit 12 calculates an ego vehicle position with the locator, based on the received GNSS signal, selects a surrounding map from the map database, and outputs the ego vehicle position and the surrounding map.

The communication unit 13 transmits and receives wireless communications between vehicles (vehicle-to-vehicle communications) and wireless communications between a vehicle and an infrastructure facility (road-to-vehicle communications).

The vehicle sensor 14 acquires information on travel of the ego vehicle, such as engine system driving information, brake system operating information, and steering system operating information of the vehicle drive device 16.

The automated driving control device 15 determines automated driving and controls the vehicle. The automated driving control device 15 includes an automated driving determination unit that inputs the object information from the sensor, the ego vehicle position information, and the surrounding map information to calculate an action, a path, a speed, or the like required for automated driving. The automated driving control device 15 includes a vehicle control unit that inputs a result of the calculation by the automated driving determination unit to control the vehicle drive device 16.

The vehicle drive device 16 includes and controls an engine system, a brake system, and a steering system.

The evaluation scenario generation device 1 includes evaluation scenario elements 2, parameters 3, a group definition file 4, an evaluation scenario generation unit 5, and an evaluation scenario extraction unit 6, which are illustrated in a simplified manner. These units have been described above in Embodiment 1; therefore, the description thereof is omitted in Embodiment 2.

### <Motion of ego vehicle V0>

A motion of the ego vehicle V0 of FIG. 7 will be described below with reference to the specific examples of FIGS. 8A to 8D.

FIG. 8A illustrates an exemplary scene in which the evaluation scenario generation device 1 is used for vehicle control. In FIG. 8A, the ego vehicle V0 and a preceding surrounding vehicle V1 travel on a second lane, and a surrounding vehicle V2 and a surrounding vehicle V3 travel on a first lane. In this situation, if the preceding surrounding vehicle V1 decelerates suddenly, the ego vehicle V0 needs to perform an avoidance motion for avoiding collision with the surrounding vehicle V1.

Hence, the automated driving control device 15 acquires information for specifying the situation of FIG. 8A, such as a road geometry, as well as locations, speeds, orientations, types, and shapes of the ego vehicle and a surrounding object, from the external sensor 11, the map unit 12, the communication unit 13, and the vehicle sensor 14 and outputs the acquired information to the evaluation scenario generation device 1 to determine a safe avoidance motion. Moreover, the automated driving control device 15 outputs the group definition file 4 defining the avoidance motion to the evaluation scenario generation device 1.

Using the evaluation scenario elements 2, the parameters 3, and the evaluation scenario generation unit 5, the evaluation scenario generation device 1 then generates mass evaluation scenarios comprehensively reproducing motions of surrounding objects that may occur in the future, and mass tag information items, based on the input current situation information. However, if the number of evaluation scenarios is too large, it takes time to generate the evaluation scenarios. Therefore, evaluation scenarios are generated by a limited practical number. In addition, if the simulation time for the evaluation scenarios is set to be longer than necessary, it takes time to perform subsequent simulations. Therefore, the simulation time is set at minimum for generation of the evaluation scenarios.

The evaluation scenario extraction unit 6 performs simulations of the evaluation scenarios, using the mass evaluation scenarios and mass tag information items generated by the evaluation scenario generation unit 5 as well as the group definition file 4 acquired from the automated driving control device 15. The evaluation scenario extraction unit 6 then determines whether an analysis target evaluation scenario enables the safe avoidance motion, by scene determination processing for an avoidance motion scenario.

For example, in a case where the analysis target evaluation scenario satisfies the minor entry "nonoccurrence of intrusion into avoidance area" in the major entry "scene" of FIG. 4A, it can be determined that the safe avoidance motion has been performed in the analysis target evaluation scenario. It should be noted that these simulations are performed at ultra-high speed for emphasizing a simulation speed and specializing processing required for a scene determination.

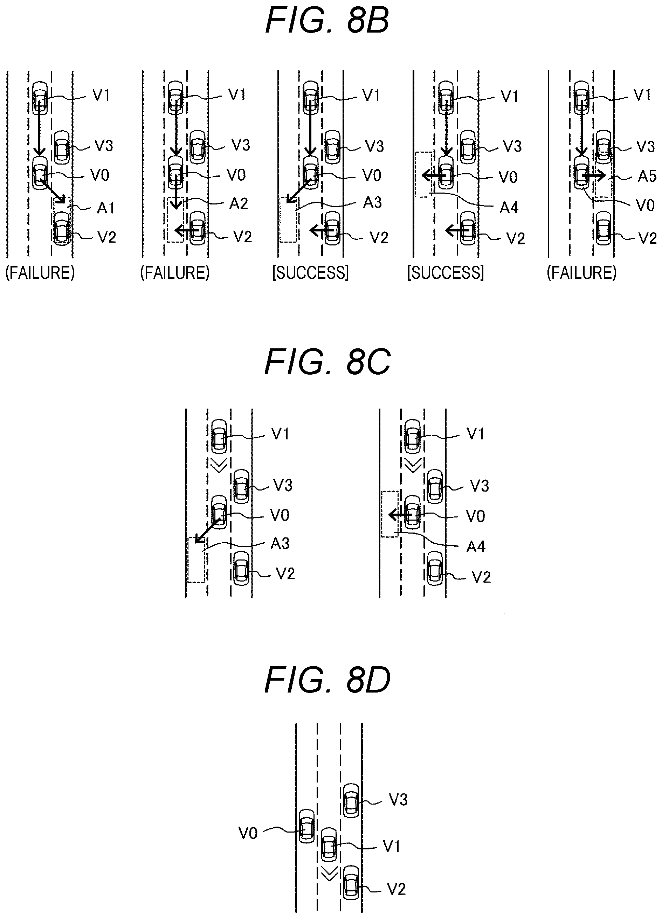

FIG. 8B is a conceptual view illustrating a result of a scene determination based on a simulation performed by the evaluation scenario extraction unit 6. It is necessary to extract such an evaluation scenario that the ego vehicle V0 can perform an avoidance motion safely in an avoidance area where the ego vehicle V0 collides with none of the surrounding vehicles.

In FIG. 8B, an avoidance area A1 is an area where the ego vehicle V0 and the surrounding vehicle V2 enter together. Therefore, this avoidance motion is evaluated as failure. An avoidance area A2 is an area where the ego vehicle V0 and the surrounding vehicle V2 enter together. Therefore, this avoidance motion is evaluated as failure. An avoidance area A3 is an area where only the ego vehicle V0 enters. Therefore, this avoidance motion is evaluated as success. An avoidance area A4 is an area where only the ego vehicle V0 enters. Therefore, this avoidance motion is evaluated as success. An avoidance area A5 is an area where the ego vehicle V0 and the surrounding vehicle V3 enter together. Therefore, this avoidance motion is evaluated as failure.

Specifically, the evaluation scenario extraction unit 6 of Embodiment 1 extracts only an avoidance motion scenario (specific traffic disturbance scenario) for evaluating and verifying the automated driving system, from the mass evaluation scenarios generated by the evaluation scenario generation unit 5. Therefore, the evaluation scenario extraction unit 6 of Embodiment 1 outputs only an evaluation scenario in which the ego vehicle and the surrounding vehicle enter an available area together. On the other hand, the evaluation scenario extraction unit 6 of Embodiment 2 extracts only a choice that may be adopted for maintaining the safe automated driving of the ego vehicle V0. Therefore, the evaluation scenario extraction unit 6 of Embodiment 2 outputs an evaluation scenario in which only the ego vehicle enters an available area.

Therefore, the evaluation scenario extraction unit 6 of the present embodiment determines, from a result of a scene determination, whether the evaluation scenario is in accord with the avoidance motion (success) defined in the group definition file, and then updates tag information items, using the group information items. After the end of analysis for all the evaluation scenarios, the evaluation scenario extraction unit 6 refers to the group information items of the mass tag information items, extracts a plurality of evaluation scenarios reproducing the safe avoidance motion, generates an evaluation scenario group (hereinafter, a candidate avoidance area) including information items, such as the position and shape of the avoidance area, as well as the longitudinal behavior, lateral behavior, and duration of the ego vehicle V0 when moving to the avoidance area, obtained by the scene determination processing based on the simulations, and outputs the generated evaluation scenario group to the automated driving control device 15. In Embodiment 2, the evaluation scenario extraction unit 6 operates after the end of analysis for all the evaluation scenarios. Depending on the urgency level of the ego vehicle V0, alternatively, the candidate avoidance area may be output to the automated driving control device 15 as quickly as possible by generating the candidate avoidance area immediately if even a single evaluation scenario reproducing the safe avoidance motion can be extracted.

FIG. 8C is a conceptual view illustrating candidate avoidance areas generated by the evaluation scenario extraction unit 6. As illustrated in FIG. 8C, the evaluation scenario extraction unit 6 extracts only the evaluation scenarios of the avoidance area A3 and avoidance area A4 where the ego vehicle V0 can perform the avoidance motion safely.

The automated driving control device 15 inputs the candidate avoidance areas to determine current situations of the ego vehicle V0, preceding surrounding vehicle V1, surrounding vehicle V2, surrounding vehicle V3, and other surrounding vehicles, and selects the optimum avoidance area A4 from the candidate avoidance areas. The automated driving control device 15 then performs optimizations by referring to information items in the candidate avoidance areas, such as the position and shape of the avoidance area A4 as well as the longitudinal behavior, lateral behavior, and duration of the ego vehicle V0 when moving to the avoidance area A4, and causes the vehicle control unit to actually control the engine system, brake system, and steering system of the vehicle drive device 16, thereby performing the avoidance motion.

FIG. 8D illustrates a situation in which the automated driving control device 15 refers to the candidate avoidance areas, controls the vehicle drive device 16, and performs the avoidance motion. In a scene in which the preceding surrounding vehicle V1, which is traveling on the second lane, decelerates suddenly so that a distance between the surrounding vehicle V1 and the subsequent vehicle becomes short suddenly, the ego vehicle V0 makes a lane change to the third lane before colliding with the preceding surrounding vehicle V1. Accordingly, the ego vehicle V0 can continue automated driving safely.

According to the present embodiment described above, in a scene in which an ego vehicle needs to perform an avoidance motion due to sudden deceleration of a preceding vehicle, safe candidate avoidance areas are generated and input for controlling the ego vehicle. It is therefore possible to prevent an accident by performing the avoidance motion of the ego vehicle.

### Embodiment 3

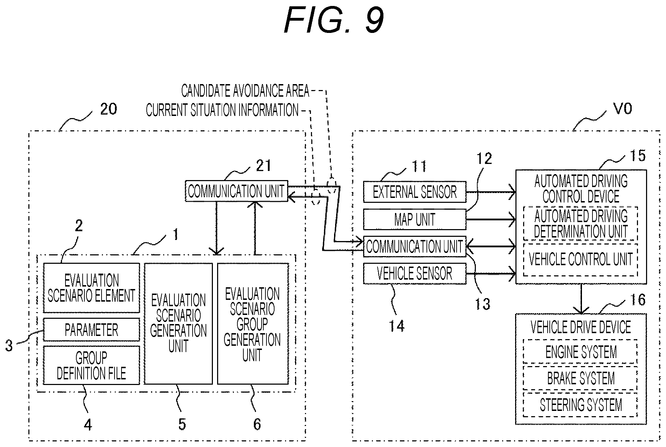

Next, an automated driving system according to Embodiment 3 of the present invention will be described with reference to FIG. 9. Features in common between Embodiment 3 and Embodiment 2 are not described for avoidance of redundancy.

In Embodiment 2, the ego vehicle V0 is equipped with the evaluation scenario generation device 1. In order to calculate, in real time, the candidate avoidance areas to be used for automated driving, however, it is necessary for the evaluation scenario generation device 1 to have high computing performance. For this reason, the cost of the ego vehicle V0 of Embodiment 2 tends to become high due to the installation of the high-performance evaluation scenario generation device 1.

Hence, according to the present embodiment, an evaluation scenario generation device 1 having high computing performance is constituted of a server 20 on a cloud so that the autonomous vehicle (ego vehicle V0) is not equipped with the evaluation scenario generation device 1. As a result, the same automated driving as that of Embodiment 2 can be realized using a relatively inexpensive vehicle configuration. It is needless to say that the server 20 (evaluation scenario generation device 1) of the present embodiment is capable of communicating with a plurality of autonomous vehicles (ego vehicles V0) in parallel; therefore, it is unnecessary to provide a server 20 for each autonomous vehicle.

FIG. 9 is a configuration diagram of the automated driving system of the present embodiment in which the server 20 and the ego vehicle V0 are connected to each other. The details of the server 20 and ego vehicle V0 will be described below with reference to FIG. 9.

### <Server 20>

The server 20 of the present embodiment includes an evaluation scenario generation device 1 and a communication unit 21. As in the evaluation scenario generation device 1 of Embodiment 2, the evaluation scenario generation device 1 includes evaluation scenario elements 2, parameters 3, a group definition file 4, an evaluation scenario generation unit 5, and an evaluation scenario extraction unit 6. The communication unit 21 is a unit for wirelessly communicating with a communication unit 13 of the ego vehicle V0. The communication unit 21 transmits current situation information received from the ego vehicle V0 to the evaluation scenario generation device 1. Moreover, the communication unit 21 transmits a candidate avoidance area received from the evaluation scenario generation device 1 to the ego vehicle V0.

### <Ego vehicle V0>

The ego vehicle V0 of the present embodiment is basically equal to the ego vehicle V0 of Embodiment 2 from which the evaluation scenario generation device 1 is excluded. However, the communication unit 13 of the present embodiment is different from the communication unit 13 of Embodiment 2 in the following respects. Specifically, the communication unit 13 of the present embodiment transmits current situation information output from, for example, an external sensor 11 to the communication unit 21 of the server 20. Moreover, the communication unit 13 of the present embodiment receives, from the communication unit 21, a candidate avoidance area calculated by the evaluation scenario generation device 1 of the server 20. Methods of generating and using the current situation information and candidate avoidance area are similar to those of Embodiment 2. Therefore, these methods are not described in the present embodiment for avoidance of redundancy.

According to the present embodiment described above, even the ego vehicle V0, which is not equipped with the evaluation scenario generation device 1, is capable of achieving automated driving control similar to that of Embodiment 2, by cooperation with the evaluation scenario generation device 1 in the server 20.

It should be noted that the present invention is not limited to the foregoing embodiments, and involves various modifications and equivalent configurations within the scope of the claims. For example, the foregoing embodiments have been described in detail for the purpose of making the present invention easy to understand, and the present invention is not necessarily limited to those having all the configurations described above. A part of the configuration of one of the embodiments may be replaced with the configuration of another one of the embodiments. Alternatively, the configuration of one of the embodiments may be added to the configuration of another one of the embodiments. Alternatively, a part of the configuration of each embodiment may be subjected to addition, deletion, or replacement with another configuration.

The respective configurations, functions, processing units, processing means, and the like described above may be partially or entirely implemented by hardware in such a way that they are designed using, for example, integrated circuitry, or may be partially or entirely implemented by software in such a way that a processor interprets and executes programs for carrying out their functions.

Information on programs, tables, files, and others for implementing the respective functions can be stored in a storage device such as a memory, a hard disk, or a solid state drive (SSD) or a recording medium such as an IC card, an SD card, or a DVD.

Control lines and information lines illustrated in the respective drawings are control lines and information lines which are considered to be necessary for the description; therefore, the drawings do not necessarily depict all the control lines and information lines required for implementation. In practice, it may be considered that almost all the configurations are connected to each other.

### Reference Signs List

- 1: evaluation scenario generation device
- 2: evaluation scenario element
- 3: parameter
- 4: group definition file
- 5: evaluation scenario generation unit
- 6: evaluation scenario extraction unit
- 6a: evaluation scenario acquisition unit
- 6b: evaluation scenario execution unit
- 6c: scene determination unit
- 6d: tag information acquisition unit
- 6e: group definition file acquisition unit
- 6f: evaluation scenario analyzing unit
- 6g: evaluation scenario configuring unit
- 7: evaluation scenario group
- V0: ego vehicle
- 11: external sensor
- 12: map unit
- 13: communication unit
- 14: vehicle sensor
- 15: automated driving control device
- 16: vehicle drive device
- 20: server
- 21: communication unit
- V1, V2, V3: surrounding vehicle

## Claims

1. An evaluation scenario generation device comprising:
a storage unit that stores a plurality of evaluation scenario elements relevant to traveling environments of an ego vehicle, a plurality of parameters relevant to the evaluation scenario elements, and a group definition file defining contents relevant to categories of the evaluation scenarios;
an evaluation scenario generation unit that generates a plurality of evaluation scenarios and a plurality of tag information items, based on the plurality of evaluation scenario elements and the plurality of parameters; and
an evaluation scenario extraction unit that determines whether the evaluation scenarios are evaluation scenarios conforming to the group definition file, based on a result of a scene determination acquired by performing simulations of the evaluation scenarios based on the group definition file and the tag information items.

2. The evaluation scenario generation device according to claim 1, wherein
the evaluation scenario extraction unit includes:
a scene determination unit that inputs the tag information items to the group definition file and makes the scene determination when a content input to the group definition file is insufficient; and
an evaluation scenario analyzing unit that inputs a result of the scene determination to an insufficient portion of the group definition file and determines whether the evaluation scenarios are the evaluation scenarios conforming to the group definition file.

3. The evaluation scenario generation device according to claim 2, wherein
the evaluation scenario analyzing unit adds, when determining that the evaluation scenarios are the evaluation scenarios conforming to the group definition file, group information items of the evaluation scenarios conforming to the group definition file, to the tag information items.

4. The evaluation scenario generation device according to claim 3, wherein
the evaluation scenario extraction unit includes an evaluation scenario configuring unit that extracts an evaluation scenario including a desired one of the group information items, from the plurality of tag information items, and configures and outputs the extracted evaluation scenario as one evaluation scenario group.

5. The evaluation scenario generation device according to claim 3, wherein
as the scene determination, the scene determination unit determines, based on a relationship between the ego vehicle and a first surrounding vehicle, whether the ego vehicle and a second surrounding vehicle are in a blind spot relationship, and
the evaluation scenario analyzing unit adds, when the ego vehicle and the second surrounding vehicle are in the blind spot relationship as a result of the scene determination, information items indicating a blind spot scenario to the tag information items, as the group information items.

6. The evaluation scenario generation device according to claim 3, wherein
as the scene determination, the scene determination unit determines, based on a relationship between the ego vehicle and a first surrounding vehicle, whether a second surrounding vehicle moves to an avoidance area while the ego vehicle moves to the avoidance area, and
the evaluation scenario analyzing unit adds, when the ego vehicle and the second surrounding vehicle move to the avoidance area together as a result of the scene determination, information items indicating an avoidance motion scenario to the tag information items as the group information items.

7. The evaluation scenario generation device according to claim 1, wherein
the evaluation scenario elements include elements concerning a road, a traffic participant, a behavior of the ego vehicle, a behavior of the traffic participant, a natural and built environment, and a geographic feature.

8. The evaluation scenario generation device according to claim 1, wherein
the parameters include numeric values, ranges, and states relevant to the evaluation scenario elements.

9. The evaluation scenario generation device according to claim 1, wherein
the group definition file is prepared based on information items including a standard, a specification, and a guideline.

10. An autonomous vehicle comprising:
an evaluation scenario generation device; and
an automated driving control device,
wherein
the evaluation scenario generation device includes:
a storage unit that stores a plurality of evaluation scenario elements relevant to traveling environments of an ego vehicle, a plurality of parameters relevant to the evaluation scenario elements, and a group definition file defining contents relevant to categories of the evaluation scenarios;
an evaluation scenario generation unit that generates a plurality of evaluation scenarios and a plurality of tag information items, based on the plurality of evaluation scenario elements and the plurality of parameters;
and
an evaluation scenario extraction unit that determines whether the evaluation scenarios are evaluation scenarios conforming to the group definition file, based on a result of a scene determination acquired by performing simulations of the evaluation scenarios based on the group definition file and the tag information items,
the evaluation scenario extraction unit includes an evaluation scenario configuring unit that extracts an evaluation scenario including group information items of a desired one of the evaluation scenarios, from the plurality of tag information items, and configures and outputs the extracted evaluation scenario as one evaluation scenario group, and
the automated driving control device performs automated driving control on the ego vehicle, using an output result from the evaluation scenario configuring unit.

11. An automated driving system comprising:
a server; and
an autonomous vehicle,
wherein
the server includes:
a communication unit that communicates with the autonomous vehicle;
a storage unit that stores a plurality of evaluation scenario elements relevant to traveling environments of an ego vehicle, a plurality of parameters relevant to the evaluation scenario elements, and a group definition file defining contents relevant to categories of the evaluation scenarios;
an evaluation scenario generation unit that generates a plurality of evaluation scenarios and a plurality of tag information items, based on the plurality of evaluation scenario elements and the plurality of parameters;
and
an evaluation scenario extraction unit that determines whether the evaluation scenarios are evaluation scenarios conforming to the group definition file, based on a result of a scene determination acquired by performing simulations of the evaluation scenarios based on the group definition file and the tag information items,
the evaluation scenario extraction unit includes an evaluation scenario configuring unit that extracts an evaluation scenario including group information items of a desired one of the evaluation scenarios, from the plurality of tag information items, and configures and outputs the extracted evaluation scenario as one evaluation scenario group, and
the autonomous vehicle performs automated driving control, using an output result from the evaluation scenario configuring unit, the output result being acquired via the communication unit of the server.

12. An evaluation scenario generation method to be performed by a computer,
the evaluation scenario generation method comprising:
a step of generating a plurality of evaluation scenarios and a plurality of tag information items, based on a plurality of evaluation scenario elements and a plurality of parameters relevant to the evaluation scenario elements;
a step of making a scene determination by performing simulations of the evaluation scenarios; and
a step of determining whether the evaluation scenarios are desired evaluation scenarios, based on a result of the scene determination.
